(19) Europäisches Patentamt
European Patent Office
Office européen des brevets

(11) **EP 3 258 746 A2**

(12) **DEMANDE DE BREVET EUROPEEN**

(43) Date de publication:
**20.12.2017 Bulletin 2017/51**

(51) Int Cl.:
***H05B 33/08*** *(2006.01)*  ***F21S 8/10*** *(2006.01)*

(21) Numéro de dépôt: **17174283.6**

(22) Date de dépôt: **02.06.2017**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**MA MD**

(30) Priorité: **09.06.2016 FR 1655314**

(71) Demandeur: **Valeo Vision**
**93012 Bobigny Cedex (FR)**

(72) Inventeur: **FAIVRE, Arnaud**
**93012 BOBIGNY Cedex (FR)**

(54) **SÉCURISATION D'UN MODULE LUMINEUX COMPRENANT UNE SOURCE LASER**

(57) L'invention concerne un module lumineux comportant une source laser apte à émettre un faisceau de lumière cohérente de longueur d'onde donnée, un premier capteur apte à capter un premier signal lumineux de longueur d'onde comprise dans une première plage de longueurs d'onde centrée autour de ladite longueur d'onde donnée et un deuxième capteur apte à capter un deuxième signal lumineux de longueur d'onde comprise dans une deuxième plage de longueurs d'onde centrée autour d'une longueur d'onde distincte de ladite longueur d'onde donnée.

En particulier, le module lumineux comporte un dispositif de détection (26) apte à comparer au moins une valeur fonction desdits signaux à une valeur seuil et à commander l'arrêt de la source laser en fonction de ladite comparaison.

FIG. 3

EP 3 258 746 A2

**Description**

La présente invention appartient au domaine des modules lumineux comprenant une source laser. En particulier, elle concerne un dispositif et un procédé de sécurisation d'un tel module lumineux.

La présente invention est particulièrement avantageuse lorsqu'elle est mise en oeuvre dans un dispositif d'émission lumineuse intégré à un véhicule et comprenant le module lumineux.

On entend par « dispositif d'émission lumineuse » tout dispositif apte à émettre de la lumière. Par exemple, un projecteur ou un feu d'un véhicule, une lampe de poche, une lumière intégrée à l'intérieur d'un véhicule, une veilleuse intégrée à un siège d'un wagon de train, un composant d'un écran de télévision ou encore un projecteur de forte intensité compris sur un navire garde côte sont des exemples de dispositifs d'émission lumineuse. On entend par véhicule tout type de dispositif apte à se déplacer, tel qu'une voiture, un camion, un scooter, un avion, un train ou encore un traineau.

On entend par « module lumineux » tout sous-dispositif du dispositif d'émission lumineuse à partir duquel la lumière est émise. Ainsi, le module lumineux peut comprendre une source lumineuse.

On entend par « source laser » tout dispositif apte à produire un rayonnement spatialement et temporellement cohérent basé sur l'effet laser. Dans la suite de la présente description, les termes « source laser » et « laser » sont utilisés indifféremment.

Selon la puissance et la longueur d'onde d'émission du laser, celui-ci peut représenter un réel danger pour la vue et provoquer des brûlures irréparables de la rétine.

Néanmoins, l'utilisation de lasers est recherchée dans de nombreux produits destinés au public. Par exemple, dans l'industrie automobile, les feux et/ou projecteurs des véhicules comprenant des lasers sont recherchés pour leurs performances (portée, forme du faisceau par exemple) et leur aspect esthétique.

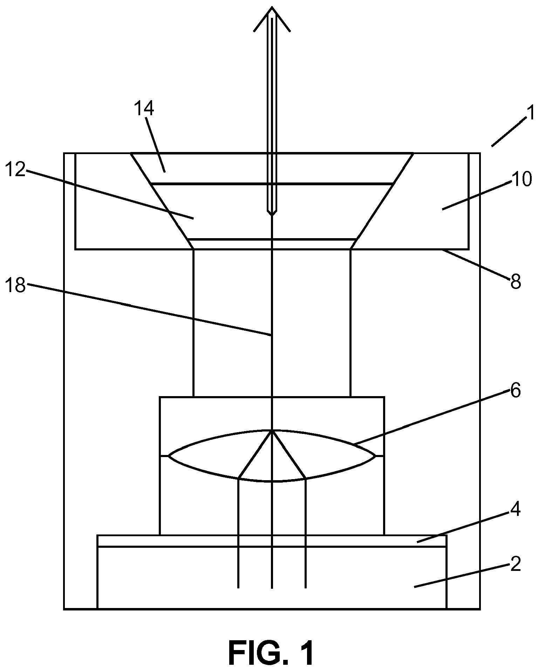

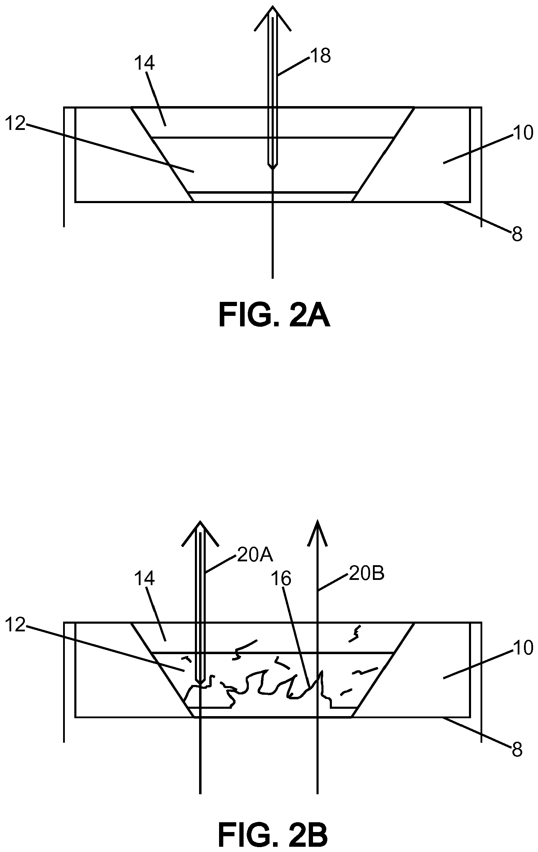

Les figures 1, 2A et 2B représentent un module source 1 connu et comprenant un module de traitement 8 apte à sécuriser un faisceau laser émis par une source laser 2. Le module source 1 présente typiquement une forme de cylindre.

En particulier, un faisceau laser 18 est généré par la source laser 2 puis est focalisé par une lentille 6 après être passé au travers d'un verre plat 4. En sortie de la lentille 6, le faisceau est cohérent, typiquement dans une longueur d'onde dans le bleu. A ce stade, et de par sa cohérence, le faisceau est dangereux. En effet, un tel faisceau est dit de classe 4, dans la norme française NF EN 60825-1, soit la classe la plus dangereuse.

Pour rendre possible l'utilisation d'un tel faisceau laser dans des applications grand public, il a pu être proposé de traiter le faisceau laser 18 par un module de traitement 8.

Le module de traitement 8 comprend un anneau 10 en céramique présentant un revêtement réfléchissant, une pastille 12 de matériau photo luminescent et une vitre de protection 14. Le matériau photoluminescent est par exemple de type YaG, pour grenat d'yttrium-aluminium.

Comme cela est détaillé à la figure 2A, lorsque le faisceau 18 qui, au sortir de la lentille, est de classe 4 et cohérent, arrive sur la pastille 12, une partie des signaux constituant le faisceau sont convertis pour présenter une longueur d'onde dans le jaune. Ces signaux convertis s'additionnent avec des signaux qui n'ont pas été convertis de sorte que le faisceau résultant n'est plus cohérent. Ainsi, le faisceau sortant du module de traitement n'est plus de classe 4 est peut être utilisé pour une application grand public.

Toutefois, dans certaines applications telles que l'industrie automobile, le module de traitement peut-être soumis à des chocs ou autres détériorations. Dans ce cas, la pastille 12 de phosphore peut-être abimée et présenter des détériorations 16, telles que fissures ou brisures. Dans cette situation, illustrée à la figure 2B, certains faisceaux comme le faisceau 20A peuvent tout de même être correctement traités par le module de traitement 8. Toutefois, d'autres faisceaux peuvent ne pas être correctement traités et ainsi diffuser un faisceau laser 20B cohérent très dangereux.

D'autres types de détériorations, moins visibles et donc plus difficiles à détecter peuvent apparaitre. Par exemple, un véhicule comprenant ce type de module lumineux et étant soumis fréquemment à des conditions météorologique particulières (chaud ou froid extrêmes prolongés) ou à des chocs faibles mais très fréquents peut présenter une dégradation lente du module de traitement 8. Il est particulièrement difficile de détecter ce type de détérioration lente.

Il existe donc un besoin pour détecter de manière sûre et efficace tous types de détériorations de modules lumineux intégrant une source laser.

La présente invention vient améliorer la situation.

A cet effet, un premier aspect de l'invention concerne un module lumineux comportant :

- une source laser apte à émettre un faisceau de lumière cohérente de longueur d'onde donnée;
- un premier capteur apte à capter un premier signal lumineux de longueur d'onde comprise dans une première plage de longueurs d'onde centrée autour de ladite longueur d'onde donnée ;
- un deuxième capteur apte à capter un deuxième signal lumineux de longueur d'onde comprise dans une deuxième plage de longueurs d'onde centrée autour d'une longueur d'onde distincte de ladite longueur d'onde donnée ;

caractérisé en ce que le module lumineux comporte un dispositif de détection apte à comparer au moins une valeur fonction desdits signaux à une valeur seuil et à commander l'arrêt de la source laser en fonction de ladite comparaison.

Une détérioration de la source laser entrainant la libération d'un faisceau laser dangereux est ainsi détectable. En particulier, une détérioration de la pastille 12 est facilement détectable par les premier et deuxième capteurs.

En outre, la présence de deux capteurs aptes à détecter des signaux de longueurs d'onde différentes rend possible une détection fine d'une détérioration du module lumineux. En particulier, les détections lentes sont détectées plus rapidement lorsque des données sur des signaux de plusieurs longueurs d'onde sont disponibles.

Dans un mode de réalisation, les premier et deuxième capteurs sont compris dans une photodiode. Par exemple, la photodiode peut comprendre un capteur RGB, pour Red, Green, Blue soit rouge, vert, bleu en français. Un type de capteur RGB peut comprendre un capteur équipé de filtres différents, typiquement rouge, vert et bleu.

L'utilisation de la photodiode réduit l'encombrement du module lumineux de par les dimensions réduites d'une telle photodiode. Le regroupement des capteurs simplifie en outre les raccordements entre ces capteurs et le dispositif de détection.

Dans un autre mode de réalisation, au moins un capteur émet un signal numérique relatif au signal lumineux capté. Ainsi, un signal aisément interprétable est directement disponible en sortie dudit au moins un capteur. En outre, la précision des données reçus par le dispositif de détection est améliorée. La précision est notamment améliorée en numérisant les signaux au niveau des capteurs car les informations transmises par des signaux numériques sont moins susceptibles d'être modifiées par des erreurs de transmission entre capteur et dispositif de détection que des signaux analogiques.

Dans un mode de réalisation, le dispositif de détection comporte en outre :

- un module de filtrage agencé pour effectuer un filtrage du signal numérique sur un intervalle prédéterminé, la valeur fonction desdits signaux étant déterminée en fonction dudit filtrage.

Dans un mode de réalisation, le filtrage du signal est une moyenne du signal numérique sur l'intervalle prédéterminé. En variante, le filtrage peut être une pondération ou tout autre type d'opération sur l'intervalle prédéterminé.

L'intervalle prédéterminé correspond par exemple aux dix dernières valeurs reçues des capteurs, dans le cas où des valeurs discrètes sont acquises.

Le module de filtrage réduit sensiblement l'incidence d'erreurs ponctuelles des capteurs. En effet, il est possible que, ponctuellement, une valeur supérieure ou inférieure aux différents seuils soit détectée et ce en raison d'une erreur dans l'acquisition de cette valeur. Si cette valeur n'est pas moyennée par d'autres valeurs, une détection de détérioration de la source laser sera détectée de manière erronée.

Dans un autre mode de réalisation, la valeur fonction desdits signaux est une valeur caractéristique d'une intensité lumineuse du premier signal ou du deuxième signal. Une telle détection directe rend possible la détection rapide d'une détérioration de la source et/ou d'un déplacement brutal du module de traitement destiné à filtrer les faisceaux laser dangereux.

Dans un mode de réalisation, la valeur fonction desdits signaux est une valeur caractéristique d'un ratio entre le deuxième signal et le premier signal.

La prise en compte d'un ratio entre des signaux de différentes longueurs d'onde rend possible un suivi fin de déviations du spectre des rayonnements constituant le faisceau émis par le module lumineux. La variation de ces ratios peut notamment témoigner d'une détérioration lente du module lumineux, et notamment du module de traitement.

En effet, en reprenant l'exemple donné ci-avant en référence aux figures 1 à 2B, une dégradation lente de la pastille 12 de matériau photoluminescent peut avoir pour conséquence de réduire le filtrage partiel en signaux présentant une longueur d'onde dans le jaune. Ainsi, la part de signaux dans le jaune s'additionnant avec les signaux dans le bleu se réduit progressivement avec la dégradation du matériau photoluminescent.

Ce phénomène a pour conséquence de réduire l'incohérence introduite par l'addition avec des signaux dans le jaune. L'augmentation progressive de la cohérence dans le bleu rend le faisceau émis dangereux.

De plus, la seule prise en considération de l'intensité lumineuse des signaux, dans les longueurs d'ondes concernées, prises individuellement, ne permet pas de détecter une variation de la cohérence du faisceau global émis en sortie. En effet, il est possible que l'intensité totale du signal dans le bleu reste constante ou n'augmente que faiblement mais que la part de ce signal dans le faisceau global émis augmente sensiblement. Dans cette situation, le faisceau global devient cohérent, et donc dangereux, sans que l'intensité dans le bleu n'ait beaucoup augmenté.

Il est donc particulièrement avantageux de prendre en compte un ratio entre les signaux pour détecter une détérioration lente.

Dans un autre mode de réalisation, le dispositif de détection comporte en outre un module d'autodiagnostic agencé pour comparer ladite au moins une valeur fonction desdits signaux à une valeur seuil de fonctionnement. La sécurisation du module lumineux est ainsi améliorée car une défaillance du module de détection peut-être détectée.

Dans un mode de réalisation, le dispositif de détection est en outre configuré pour effectuer les étapes de :

- acquisition d'un premier signal lumineux de longueur d'onde comprise dans une première plage de longueurs d'onde centrée autour de ladite longueur d'onde donnée ;

- acquisition d'un deuxième signal lumineux de longueur d'onde comprise dans une deuxième plage de longueurs d'onde centrée autour d'une longueur d'onde distincte de ladite longueur d'onde donnée ;

- comparaison par un module de détection d'au moins une première valeur fonction desdits signaux à une première valeur seuil;

- arrêt de la source laser en fonction de ladite comparaison.

Dans un autre mode de réalisation, la source laser est arrêtée si ladite première valeur fonction desdits signaux est supérieure à la première valeur seuil.

Dans un mode de réalisation, le dispositif de détection est en outre configuré pour effectuer les étapes :

- comparaison d'au moins une deuxième valeur fonction desdits signaux à une deuxième valeur seuil ;

- détection d'un dysfonctionnement du module de détection si ladite deuxième valeur fonction desdits signaux est inférieure à la deuxième valeur seuil.

Dans un mode de réalisation, la première et/ou la deuxième valeur fonction desdites signaux est une valeur caractéristique d'une intensité lumineuse du premier signal ou du deuxième signal. Dans un autre mode de réalisation, la première et/ou la deuxième valeur fonction desdites signaux est une valeur caractéristique d'un ratio entre le deuxième signal et le premier signal.

Un deuxième aspect de l'invention concerne un procédé de traitement de signaux générés par une source laser comprise dans un module lumineux, la source laser étant apte à émettre un faisceau de lumière cohérente de longueur d'onde donnée, le procédé comprenant les étapes de :

- acquisition d'un premier signal lumineux de longueur d'onde comprise dans une première plage de longueurs d'onde centrée autour de ladite longueur d'onde donnée ;
- acquisition d'un deuxième signal lumineux de longueur d'onde comprise dans une deuxième plage de longueurs d'onde centrée autour d'une longueur d'onde distincte de ladite longueur d'onde donnée ;
- comparaison par un module de détection d'au moins une première valeur fonction desdits signaux à une première valeur seuil ;
- arrêt de la source laser en fonction de ladite comparaison.

Dans un mode de réalisation du deuxième aspect de l'invention, la source laser est arrêtée si ladite première valeur fonction desdits signaux est supérieure à la première valeur seuil.

Dans un autre mode de réalisation du deuxième aspect de l'invention, le procédé comporte en outre, après l'étape d'acquisition par le deuxième capteur, les étapes de :

- comparaison d'au moins une deuxième valeur fonction desdits signaux à une deuxième valeur seuil ;
- détection d'un dysfonctionnement du module de détection si ladite deuxième valeur fonction desdits signaux est inférieure à la deuxième valeur seuil.

Dans un mode de réalisation du deuxième aspect de l'invention, la première et/ou la deuxième valeur fonction desdites signaux est une valeur caractéristique d'une intensité lumineuse du premier signal ou du deuxième signal.

Dans un autre mode de réalisation du deuxième aspect de l'invention, la première et/ou la deuxième valeur fonction desdites signaux est une valeur caractéristique d'un ratio entre le deuxième signal et le premier signal.

Un troisième aspect de l'invention concerne un programme informatique comportant des instructions pour la mise en oeuvre du procédé selon le deuxième aspect de l'invention, lorsque ces instructions sont exécutées par un processeur.

D'autres caractéristiques et avantages de l'invention apparaîtront à l'examen de la description détaillée ci-après, et des dessins annexés sur lesquels:

- la figure 1 illustre un module lumineux connu ;

- la figure 2A illustre un module de traitement connu apte à filtrer un faisceau laser dangereux ;

- la figure 2B illustre le module de traitement connu lorsqu'il est détérioré ;

- la figure 3 illustre le module lumineux selon l'invention, dans un mode de réalisation ;

- la figure 4 est un schéma du procédé selon l'invention, dans un mode de réalisation ;

- la figure 5 illustre la réponse d'une source laser selon un mode de réalisation de l'invention ;

- la figure 6 illustre la réponse d'une source laser selon un autre mode de réalisation de l'invention ;

- la figure 7 illustre un microcontrôleur selon un mode de réalisation de l'invention.

Le module lumineux selon l'invention est décrit ci-après dans son application, non limitative, à un dispositif d'émission lumineuse d'un véhicule automobile. D'autres applications telles qu'un dispositif selon l'invention utilisé comme projecteur ou décoration intérieure d'un véhicule automobile, comme guirlande de noël ou encore comme panneau de signalisation sont également envisageables.

Le module est par exemple configuré pour mettre en oeuvre une ou plusieurs fonctions photométriques.

Une fonction photométrique est par exemple une fonction d'éclairage et/ou signalisation visible pour un oeil humain. On remarque que ces fonctions photométriques peuvent faire l'objet d'une ou plusieurs règlementations établissant des exigences de colorimétrie, d'intensité, de répartition spatiale selon une grille dite photométrique, ou encore de plages de visibilité de la lumière émise.

Un dispositif d'émission lumineuse comprenant le module selon l'invention est par exemple un dispositif d'éclairage et constitue alors un projecteur - ou phare avant - de véhicule. Il est alors configuré pour mettre en oeuvre une ou plusieurs fonctions photométriques par exemple choisie(s) parmi une fonction de feux de croisement dite « fonction code » (réglementations 87 et 123 UNECE), une fonction feu de position (réglementation 007 UNECE), une fonction de feux de route dite « fonction route » (réglementation 123 UNECE), une fonction antibrouillard (réglementations 019 et 038 UNECE).

Alternativement, le dispositif est un dispositif de signalisation destiné à être agencé à l'avant ou à l'arrière du véhicule.

Lorsqu'il est destiné à être agencé à l'avant, ces fonctions photométriques incluent une fonction d'indication de changement de direction (réglementation 006 UNECE), une fonction d'éclairage diurne connue sous l'acronyme anglophone DRL (réglementation 087 UNECE), pour « Daytime Running Light », une fonction de signature lumineuse avant.

Lorsqu'il est destiné à être agencé à l'arrière, ces fonctions photométriques incluent une fonction d'indication de recul (réglementation 023 UNECE), une fonction stop (réglementation 007 UNECE), une fonction antibrouillard (réglementations 019 et 038 UNECE), une fonction d'indication de changement de direction (réglementation 006 UNECE), une fonction de signature lumineuse arrière.

Alternativement, le dispositif est prévu pour l'éclairage de l'habitacle d'un véhicule et est alors destiné à émettre de la lumière principalement dans l'habitacle du véhicule.

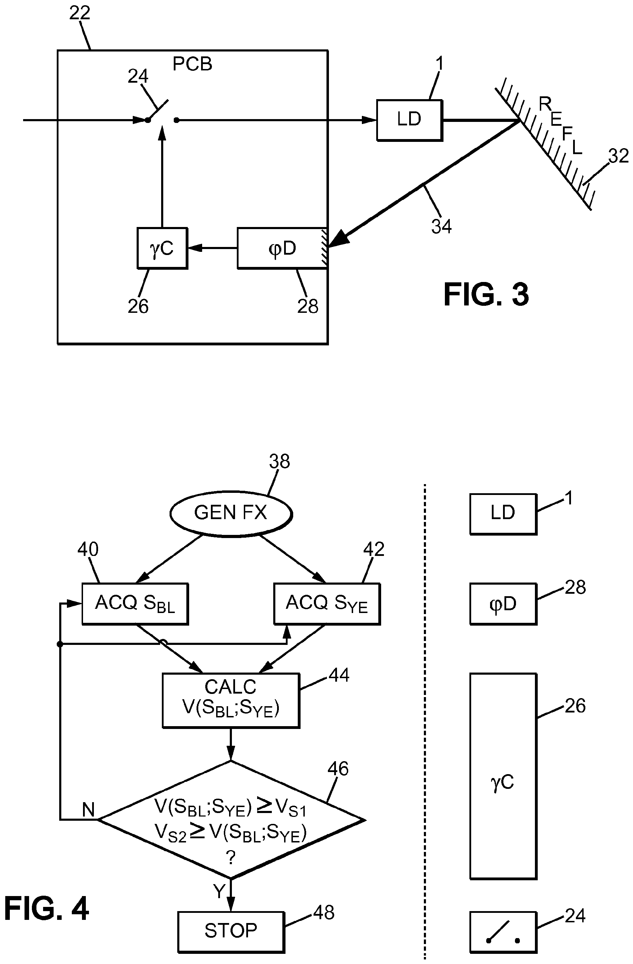

On décrit maintenant en référence aux **figures 3** et **4** le dispositif et procédé de traitement de signaux générés par une source laser comprise dans un module lumineux, selon un mode de réalisation de l'invention.

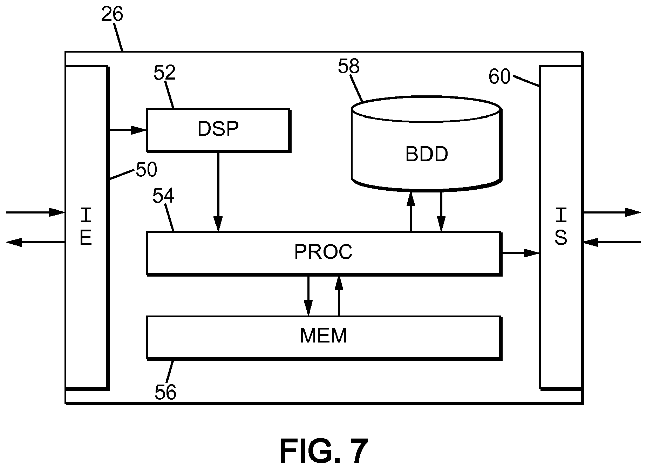

Le module lumineux, ici assimilé au dispositif d'émission lumineuse, comprend un circuit intégré 22 sur lequel un interrupteur 24 commandé par un microcontrôleur 26 recevant lui-même des données d'une photodiode 28 est présent. La photodiode 28 peut comprendre un capteur RGB, pour Red, Green, Blue soit rouge, vert, bleu en français. Un type de capteur RGB peut comprendre un capteur équipé de filtres différents, typiquement rouge, vert et bleu. Une architecture possible du microcontrôleur 26 est détaillée ci-après en référence à la figure 7.

Les composants 24, 26 et 28 peuvent également être compris sur des circuits intégrés différents, ou ne pas être compris sur des circuits intégrés.

Le module lumineux comprend en outre le module source 1 décrit ci-avant en référence aux figures 1 à 2B. Le module 1 est alimenté en énergie via l'interrupteur 24, si bien que le module 1 n'est pas allumé si l'interrupteur 24 est ouvert. L'interrupteur peut prendre diverses formes et n'est pas limité à un interrupteur mécanique d'un circuit électrique.

En particulier, l'interrupteur peut être intégré au microcontrôleur 26. Dans cette situation, le fonctionnement de l'interrupteur peut consister en l'émission d'une instruction de fonctionnement ou de non-fonctionnement du microcontrôleur 26 vers le module 1.

Le module source 1 émet un faisceau 34 qui est réfléchi sur un réflecteur 32 pour être dirigé vers la photodiode 28. Le faisceau émis en sorti du module 1 peut typiquement être partiellement réfléchi par le réflecteur 32 pour qu'une partie du faisceau soit projetée sur la photodiode et que le reste du faisceau soit utilisé pour assurer la fonction de signalement et/ou projection du module lumineux. La photodiode 28 peut également être placée en sortie du module 1 sans qu'il ne soit prévu de réflecteur.

Ainsi, le module lumineux comprend une source laser, comprise dans le module 1, apte à émettre un faisceau de lumière cohérente de longueur d'onde donnée, un premier capteur apte à capter un premier signal lumineux de longueur d'onde comprise dans une première plage de longueurs d'onde centrée autour de ladite longueur d'onde donnée et un deuxième capteur apte à capter un deuxième signal lumineux de longueur d'onde comprise dans une deuxième plage de longueurs d'onde centrée autour d'une longueur d'onde distincte de ladite longueur d'onde donnée. Le premier et le deuxième capteur sont typiquement compris dans la photodiode 28.

Le module lumineux comporte un dispositif de détection, typiquement compris ou constitué par le microcontrôleur 26, apte à comparer au moins une valeur fonction desdits signaux à une valeur seuil et à commander l'arrêt de la source laser en fonction de ladite comparaison.

Le procédé est maintenant décrit en référence à la figure 4. Sur cette figure, les étapes du procédé sont schématiquement représentées sur la partie gauche et un exemple de modules/dispositifs en charge d'effectuer ces étapes est donné sur la partie droite de la figure.

Ainsi, un faisceau FX de lumière cohérente de longueur d'onde donnée est généré par le module source 1 à l'étape 38.

A une étape 40, un premier signal lumineux $S_{BL}$ de longueur d'onde comprise dans une première plage de longueurs d'onde centrée autour de ladite longueur d'onde donnée est acquis par la photodiode 28. Par exemple, la longueur d'onde donnée peut correspondre à la couleur bleue, soit sensiblement entre 470 et 490 nm. La première plage centrée autour de cette longueur d'onde est par exemple 450 à 500 nm.

A une étape 42, un deuxième signal lumineux $S_{YE}$ de longueur d'onde comprise dans une deuxième plage de longueurs d'onde centrée autour d'une longueur d'onde distincte de ladite longueur d'onde donnée est acquis. Par exemple, la longueur d'onde distincte peut correspondre à la couleur jaune, soit sensiblement entre 574 et 582 nm. La deuxième plage centrée autour de cette longueur d'onde est par exemple 555 à 586 nm.

Les capteurs peuvent être configurés pour intégrer un Convertisseur Analogique Numérique, ou CAN, pour que les signaux analogiques acquis soit directement convertis en signaux binaires.

En outre, les capteurs et/ou le microcontrôleur 26 peuvent comprendre un module de filtrage agencé pour effectuer une moyenne ou une pondération des signaux numériques acquis par les capteurs sur un intervalle prédéterminé. L'intervalle prédéterminé correspond par exemple aux dix dernières valeurs reçues des capteurs, dans le cas où des valeurs discrètes sont acquises.

Une première valeur $V(S_{BL} ; S_{YE})$ fonction des premier et deuxième signaux, et/ou de la valeur filtrée susmentionnée, est ensuite calculée à l'étape 44. Une deuxième valeur également fonction des premier et deuxième signaux peut également être calculée à l'étape 44.

La première et/ou la deuxième valeur peut-être une valeur caractéristique d'une intensité lumineuse du premier signal ou du deuxième signal. Des exemples de calcul sont donnés ci-après :

- $$V(S_{BL} ; S_{YE}) = k.I_{MAX}(S_{BL})$$

- $$V(S_{BL} ; S_{YE}) = k.I_{MOY}(S_{BL})$$

- $$V(S_{BL} ; S_{YE}) = k.I_{MAX}(S_{YE})$$

- $$V(S_{BL} ; S_{YE}) = k.I_{MOY}(S_{YE})$$

- $$V(S_{BL} ; S_{YE}) = k. \left(I_{MOY}(S_{BL}) + I_{MOY}(S_{YE})\right)/2$$

Dans un autre mode de réalisation, la première et/ou la deuxième valeur fonction desdites signaux est une valeur caractéristique d'un ratio entre le deuxième signal et le premier signal. Des exemples de calcul sont donnés ci-après :

- $$V(S_{BL} ; S_{YE}) = k.I_{MAX}(S_{YE})/I_{MAX}(S_{BL})$$

- $$V(S_{BL} ; S_{YE}) = k.I_{MAX}(S_{BL})/I_{MAX}(S_{YE})$$

- $$V(S_{BL}\,;\,S_{YE}) = k.I_{MOY}(S_{YE})/I_{MOY}(S_{BL})$$

- $$V(S_{BL}\,;\,S_{YE}) = k.I_{MOY}\,(S_{BL})/I_{MOY}(S_{YE})$$

Avec $I_{MAX}$ et $I_{MOY}$ correspondant respectivement à l'intensité lumineuse maximale et à l'intensité lumineuse moyenne (par exemple sur 1 seconde), et $k$ est nombre réel, $k$=1 dans un mode de réalisation.

Ces intensités peuvent par exemple être exprimées en candela. Ces intensités peuvent également correspondre à une puissance par unité de surface sur laquelle le faisceau est reçu, elles peuvent alors être exprimées en $\mu W/cm^2$.

Une fois $V(S_{BL}\,;\,S_{YE})$ calculé, cette valeur est comparée à une valeur seuil $V_{S1}$ à l'étape 46. La valeur seuil est déterminée pour que la situation où $V(S_{BL}\,;\,S_{YE}) \geq V_{S1}$ traduisent un dysfonctionnement du module source 1, et notamment une détérioration du module de traitement 8.

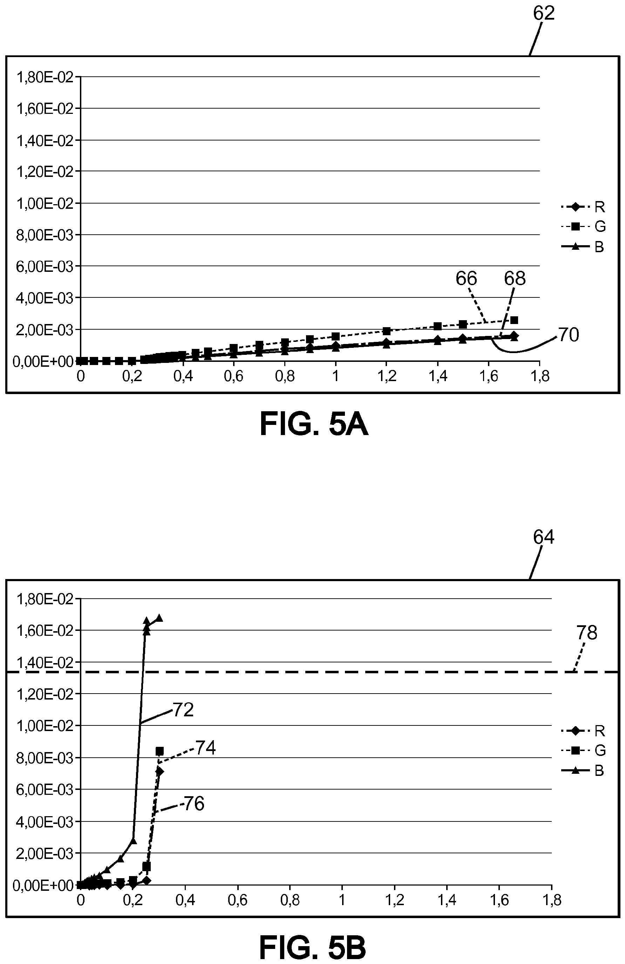

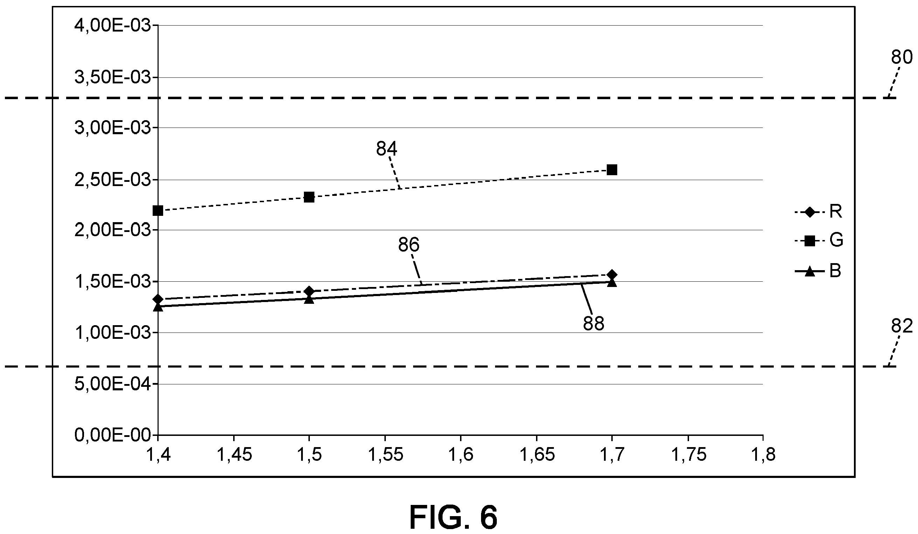

Par exemple, et comme cela est illustré aux **figures 5** et **6**, $V_{S1}$ peut être sensiblement égale à 1.35E-02 $\mu W/cm^2$, comme illustré à la référence 78.

La figure 5 illustre les courbes représentatives de $V(S_{BL}\,;\,S_{GR}\,;\,S_{RD})$. $S_{GR}$ correspond à un signal lumineux dans le vert et $S_{RD}$ un signal lumineux dans le rouge dans le cas où le module source 1 fonctionne normalement, sur la partie gauche 62, et dans le cas où il est détérioré, sur la partie droite 64. Il y a donc ici trois valeurs de $V(S_{BL}\,;\,S_{GR}\,;\,S_{RD})$ différentes qui sont prises en compte, chacune étant comparée avec $V_{S1}$. Les valeurs de $V(S_{BL}\,;\,S_{GR}\,;\,S_{RD})$ sont exprimées en $\mu W/cm^2$, en ordonnées, par rapport au courant d'alimentation en Ampères du module source 1, en abscisses.

Dans cet exemple, les courbes 66, 68 et 70 représentent respectivement une intensité lumineuse caractéristique du signal dans le vert, le rouge et le bleu. De même, sur la partie droite, les courbes 74, 76 et 72 représentent respectivement une intensité lumineuse caractéristique du signal dans le vert, le rouge et le bleu.

Sur la partie droite 64, la valeur de $V(S_{BL}\,;\,S_{GR}\,;\,S_{RD})$ correspondant au bleu croit fortement au-dessus de 0.2 Ampères, si bien qu'elle dépasse le seuil $V_{S1}$. Cette situation correspond au cas où une détérioration du module source 1 a pour effet laisser passer des faisceaux cohérents qui sont potentiellement dangereux.

A l'étape 46, la ou les valeurs de $V(S_{BL}\,;\,S_{YE})$ peuvent également être comparées à un deuxième valeur seuil $S_{S2}$, référence 82 sur la figure 6. La référence 80 correspond à $V_{S1}$ sur la figure 6.

En particulier, un dysfonctionnement est détecté si $V(S_{BL}\,;\,S_{YE}) \leq V_{S2}$. Cette situation correspond au cas où un défaut est présent dans le dispositif de détection, typiquement au niveau du microcontrôleur 26, de la photodiode 28 et/ou du module source 1. En effet, si la valeur de $V(S_{BL}\,;\,S_{YE})$ est inférieure à un seuil, cela signifie que le module source n'émet plus correctement ou que les premier et/ou deuxième signaux ne sont plus correctement acquis par la photodiode et/ou traités par le microcontrôleur 26. Ces fonctionnalités d'auto-détection d'un dysfonctionnement sont typiquement comprises dans un module d'autodiagnostic, par exemple intégré au microcontrôleur 26.

On a décrit ci-dessus le cas où la même valeur $V(S_{BL}\,;\,S_{YE})$ est utilisé pour la comparaison à $V_{S1}$ et pour la comparaison à $V_{S2}$. Dans un mode de réalisation, des valeurs de $V(S_{BL}\,;\,S_{YE})$ différentes sont utilisées pour chacune des comparaisons. Par exemple, la valeur de $V(S_{BL}\,;\,S_{YE})$ utilisée pour la comparaison à $V_{S1}$ est $k.I_{MAX}(S_{YE})/I_{MAX}(S_{BL})$ et la valeur de $V(S_{BL}\,;\,S_{YE})$ utilisée pour la comparaison à $V_{S2}$ est $k.I_{MAX}(S_{BL})$.

Si, à l'étape 46, il n'est pas détecté de dépassement des seuils $V_{S1}$ et $V_{S2}$, le procédé reprend aux étapes 40 et 42 de sorte que de nouveaux signaux sont captés.

Si, à l'étape 46, il est détecté un dépassement des seuils $V_{S1}$ et/ou $V_{S2}$, les procédé se poursuit à l'étape d'arrêt 48. A cette étape 48, le microcontrôleur envoie une instruction d'arrêt d'émission du module source 1, soit en ouvrant l'interrupteur d'alimentation 24, soit en envoyant directement une instruction d'arrêt au module source 1. Le module lumineux est sécurisé et le module source 1 n'envoie plus de faisceaux néfastes.

Un message d'alerte, détaillant par exemple si l'alerte a été générée à cause d'un dépassement de seuil maximum ou minimum, peut également être généré à l'étape 48.

Le détail d'un microcontrôleur 26, à partir duquel les étapes sont mise en oeuvre les étapes du procédé décrit en référence à la figure 3, notamment, est ici décrit en référence à la **figure 7**.

Ce microcontrôleur 26 peut prendre la forme d'un boitier comprenant des circuits imprimé, d'une puce électronique, d'un circuit programmable tel qu'un FPGA, pour « Field-Programmable Gate Array », réseau de portes programmables en français, de tout type d'ordinateur ou de tout type de sous-partie du circuit imprimé 22.

Le microcontrôleur 26 comprend une mémoire vive 56 pour stocker des instructions pour la mise en oeuvre par un processeur 54 des étapes du procédé décrit en référence à la figure 3, notamment. Le dispositif comporte aussi une mémoire de masse 58 pour le stockage de données destinées à être conservées après la mise en oeuvre du procédé, par exemple pour établir des statistiques sur l'historique des détections.

Le microcontrôleur 26 peut en outre comporter un processeur de signal numérique (DSP) 52. Ce DSP 52 reçoit par exemple les données de la photodiode pour mettre en forme, démoduler et amplifier, de façon connue en soi ces données.

Le microcontrôleur 26 comporte également une interface d'entrée 50 pour la réception de données telles que les données reçues de la photodiode 28, des signaux d'entrée reçus d'un utilisateur, des paramètres de fonctionnement, etc. Le microcontrôleur 26 comporte en outre une interface de sortie 60 notamment pour la transmission de données telles que les instructions d'arrêt du module source 1 ou les messages d'alerte.

La présente invention ne se limite pas aux formes de réalisation décrites ci-avant à titre d'exemples ; elle s'étend à d'autres variantes.

Ainsi, on a décrit ci-avant l'invention avec des exemples de signaux dans le bleu, le jaune, le rouge et le vert. L'invention peut également être mise en oeuvre avec des signaux dans toutes les couleurs du spectre visible. En outre, comme mentionné dans le mode de réalisation décrit en référence aux figures 5 et 6, il est possible de faire les comparaisons aux valeurs seuils pour plusieurs valeurs de $V(S_{BL} ; S_{YE})$. Par exemple, la comparaison peut être effectuée avec une valeur de $V(S_{BL} ; S_{YE})$ par signal acquis.

De plus, on a décrit, notamment à la figure 2, une architecture possible de composants du module lumineux selon l'invention. L'invention peut également être mise en oeuvre avec toute autre répartition de composants. Le module lumineux peut par exemple comprendre plusieurs photodiodes, une photodiode intégrée au microcontrôleur ou encore plusieurs modules sources.

## Revendications

**1.** Module lumineux comportant :

- une source laser (2) apte à émettre un faisceau de lumière cohérente de longueur d'onde donnée ;
- un premier capteur apte à capter un premier signal lumineux de longueur d'onde comprise dans une première plage de longueurs d'onde centrée autour de ladite longueur d'onde donnée ;
- un deuxième capteur apte à capter un deuxième signal lumineux de longueur d'onde comprise dans une deuxième plage de longueurs d'onde centrée autour d'une longueur d'onde distincte de ladite longueur d'onde donnée ;

**caractérisé en ce que** le module lumineux comporte un dispositif de détection (26) apte à comparer au moins une valeur fonction desdits signaux à une valeur seuil et à commander l'arrêt de la source laser en fonction de ladite comparaison.

**2.** Module lumineux selon la revendication 1, dans lequel les premier et deuxième capteurs sont compris dans une photodiode (28).

**3.** Module lumineux selon l'une des revendications précédentes, dans lequel au moins un capteur émet un signal numérique relatif au signal lumineux capté.

**4.** Module lumineux selon la revendication 3, dans lequel le dispositif de détection (26) comporte en outre :

- un module de filtrage agencé pour effectuer un filtrage du signal numérique sur un intervalle prédéterminé, la valeur fonction desdits signaux étant déterminée en fonction dudit filtrage.

**5.** Module lumineux selon l'une des revendications précédentes, dans lequel la valeur fonction desdits signaux est une valeur caractéristique d'une intensité lumineuse du premier signal ou du deuxième signal.

**6.** Module lumineux selon l'une des revendications 1 à 4, dans lequel la valeur fonction desdits signaux est une valeur caractéristique d'un ratio entre le deuxième signal et le premier signal.

**7.** Module lumineux selon l'une des revendications précédentes, dans lequel le dispositif de détection (26) comporte :

- un module d'autodiagnostic agencé pour comparer ladite au moins une valeur fonction desdits signaux à une valeur seuil de fonctionnement.

**8.** Procédé de traitement de signaux générés par une source laser comprise dans un module lumineux, la source laser étant apte à émettre un faisceau de lumière cohérente de longueur d'onde donnée, le procédé comprenant les étapes de :

- acquisition (40) d'un premier signal lumineux de longueur d'onde comprise dans une première plage de longueurs d'onde centrée autour de ladite longueur d'onde donnée ;
- acquisition (42) d'un deuxième signal lumineux de longueur d'onde comprise dans une deuxième plage de longueurs d'onde centrée autour d'une longueur d'onde distincte de ladite longueur d'onde donnée ;
- comparaison (46) par un module de détection d'au moins une première valeur fonction desdits signaux à une première valeur seuil ($V_{S1}$) ;
- arrêt de la source laser en fonction de ladite comparaison.

**9.** Procédé selon la revendication 8, dans lequel la source laser est arrêtée si ladite première valeur fonction desdits signaux est supérieure à la première valeur seuil.

**10.** Procédé selon l'une des revendications 8 à 9, comportant en outre, après l'étape d'acquisition par le deuxième capteur, les étapes de :

- comparaison d'au moins une deuxième valeur fonction desdits signaux à une deuxième valeur seuil ($V_{S2}$) ,
- détection d'un dysfonctionnement du module de détection si ladite deuxième valeur fonction desdits signaux est inférieure à la deuxième valeur seuil.

**12.** Procédé selon l'une des revendications 8 à 11, dans lequel la première et/ou la deuxième valeur fonction desdites signaux est une valeur caractéristique d'une intensité lumineuse du premier signal ou du deuxième signal.

**13.** Procédé selon l'une des revendications 8 à 12, dans lequel la première et/ou la deuxième valeur fonction desdites signaux est une valeur caractéristique d'un ratio entre le deuxième signal et le premier signal.

**14.** Programme informatique comportant des instructions pour la mise en oeuvre du procédé selon l'une quelconque des revendications 8 à 13, lorsque ces instructions sont exécutées par un processeur (54).

**FIG. 1**

14

12

18

10

8

## FIG. 2A

20A

14

16

20B

12

10

8

## FIG. 2B

FIG. 3

FIG. 4

FIG. 5A

FIG. 5B

FIG. 6

EP 3 258 746 A2

**FIG. 7**